# EUROPEAN PATENT APPLICATION

(11) **EP 1 744 368 A2**
(43) Date of publication of application: **17.01.2007**
(21) Application number: 06253486.2
(22) Date of filing: 03.07.2006
(51) Int. Cl.: H01L 27/146, H01L 31/0312, H01L 31/101, H01L 31/0216, H01L 31/0203

(54) **Photodetection system and module**

(30) Priority: 15.07.2005 US 183363
(71) Applicant: GENERAL ELECTRIC COMPANY, Schenectady, New York 12345 (US)
(72) Inventor: Sandvik, Peter Micah, Clifton Park, New York 12065 (US); Brown, Dale Marius, Schenectady, New York 12309 (US); Burdick, William Edward, Niskayuna, New York 12309 (US); Rose, James Wilson, Guilderland, New York 12203 (US); Sherman, Donna Marie, East Greenbush, New York 12061 (US); Short, Jonathan David, Saratoga Springs, New York 12866 (US); Rao, Naresh Kesavan, Clifton Park, New York 12065 (US)
(74) Representative: Bedford, Grant Richard

(57) **Abstract**

One photodetection system includes a wide bandgap photodetector array (10) which is physically and electrically integrated on a flexible interconnect layer (18) including electrical connections (20), which is packaged in a manner for being electrically integrated with processing electronics (14) such that the packaging and the processing electronics are configured for obtaining and processing signals detected by the photodetector array, or which includes both the flexible interconnect layer and processing electronics packaging features.

## Description

The invention relates generally to semiconductor photodetector arrays and more particularly to semiconductor photodetector arrays for imaging ultraviolet radiation.

Current photodetection systems utilized for such imaging systems use either a Geiger Muller tube or a phosphor-coated silicon photodiode combined with a short pass filter in order to block light with wavelengths longer than about 300 nanometers (nm). Disadvantages of the Geiger Muller tube include very low sensitivity and the need to utilize a very high voltage power supply. The phosphor coating on a silicon photodiode, which is typically used to make it ultraviolet (UV) sensitive, degrades in time when exposed to high intensity UV, and the sensitivity of the silicon photodiode thus decreases.

More recent attempts at such imaging have include use of gallium nitride (GaN) detectors. These attempts appear promising but can be challenging due to limited availability of commercial high quality gallium nitride and aluminum gallium nitride materials.

It would be desirable to achieve a photodetector array that can withstand high energy radiation without physical damage (radiation hard), that may be tailored for use in a number of ultraviolet detection applications, and that may be used for direct detection (with no phosphor required). It would also be advantageous to provide an integrated packaging arrangement to facilitate use and applicability in a wide range of embodiments.

Briefly, in accordance with one embodiment, a photodetection system includes a wide bandgap photodetector array which is physically and electrically integrated on a flexible interconnect layer including electrical connections, which is packaged in a manner for being electrically integrated with processing electronics such that the packaging and the processing electronics are configured for obtaining and processing signals detected by the photodetector array, or which includes both the flexible interconnect layer and processing electronics packaging.

In accordance with another embodiment, a wide bandgap focal plane array module includes: an array including imaging pixels; read out electronics which may include scan registers; a substrate supporting the array and the read out electronics; and electrical interconnections coupling each pixel to the read out electronics.

Various features, aspects, and advantages of the present invention will become better understood when the following detailed description is read with reference to the accompanying drawings in which like characters represent like parts throughout the drawings, wherein:
FIG. 1 is a schematic and expanded view of a photodetection system in accordance with one embodiment.
FIG. 2 is a top view of a photodetection system in accordance with another embodiment.
FIG. 3 is a side view of the photodetection system of FIG. 2.
FIG. 4 illustrates an embodiment wherein a filter comprises an integral component of a photodetector.
FIG. 5 is a side view of a photodetector including porous silicon carbide.
FIG. 6 is a side view of an avalanche photodetector.
FIG. 7 is a perspective view of a plurality of tiled photodetector arrays.
FIG. 8 is a side view of a photodetector isolation embodiment comprising at least one trench.
FIG. 9 is a schematic block diagram of a photodetector focal plane array module in accordance with another embodiment.
FIG. 10 is a top view of an array of photodetector pixels in accordance with another embodiment.
FIG. 11 is a sectional side view along line 3-3 of FIG. 10.
FIG. 12 is a top view of a of silicon carbide pixel arrangement in accordance with another embodiment.
FIG. 13 is a sectional side view along line 5-5 of FIG. 12.
FIG. 14 is a top view illustrating a plurality of pixels similar to the pixel shown in FIG. 12.
FIG. 15 is a sectional side view of a photodetector pixel in accordance with another embodiment.
FIG. 16 is a schematic view of photodetector pixels in accordance with another embodiment.

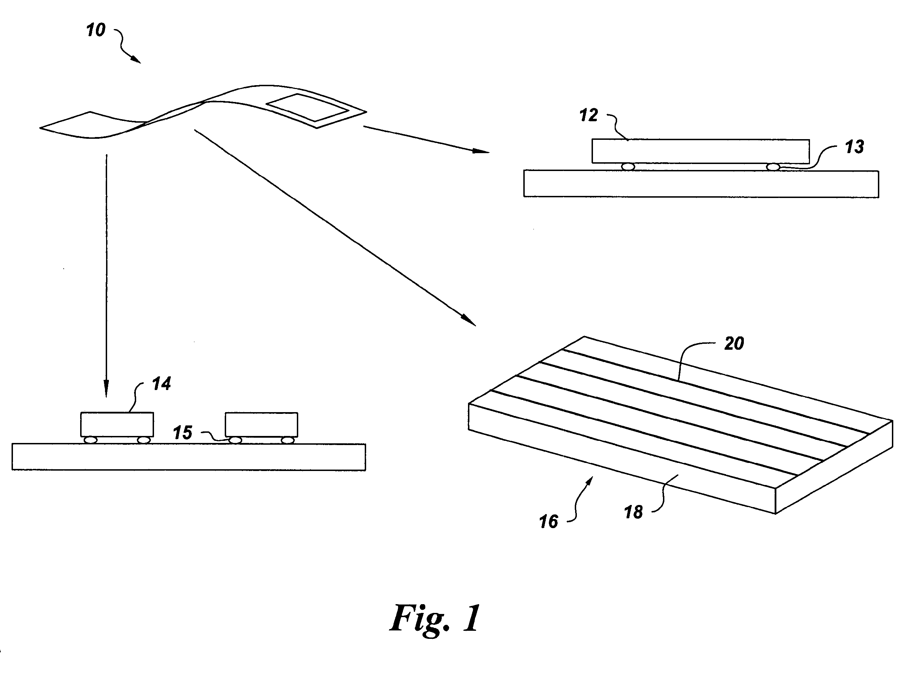

FIG. 1 is a schematic and expanded view of a photodetection system 10 in accordance with one embodiment wherein photodetection system 10 comprises a wide bandgap photodetector array 12, processing electronics 14, and packaging 16 comprising a flexible interconnect layer 18 including electrical connections 20, wherein packaging 16 is configured for electrically integrating photodetector array 12 and processing electronics 14, and wherein packaging 16 and processing electronics 14 are configured for obtaining and processing signals detected by photodetector array 12.

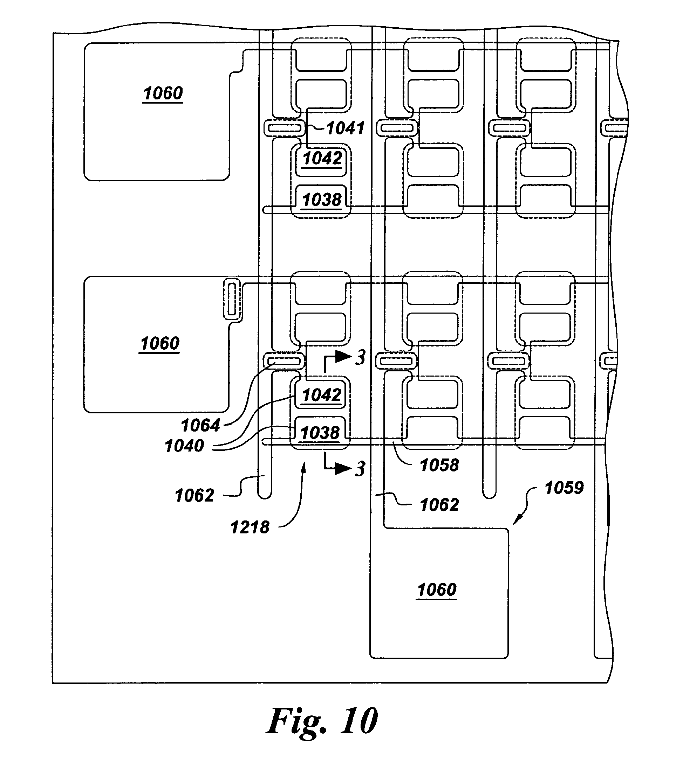

As used herein, "wide bandgap" in the context of photodetector array 12 is intended to include semiconductor materials having a bandgap greater than or equal to about 2 electron volts (eV). Several examples of such materials include most polytypes of silicon carbide, gallium nitride, aluminum gallium nitride, zinc oxide and diamond. Like most of these wide bandgap materials, silicon carbide is beneficial because it is intrinsically very radiation hard and does not require a phosphor coating to be sensitive in the ultraviolet (UV) space. In more specific embodiments photodetectors 22 of the array comprise photodiodes. In other embodiments capacitors or photoconductors may also or alternatively be selected. In even more specific embodiments, the photodetectors comprise pixels of the types described below with respect to FIGs. 10-16.

"Flexible" in the context of flexible interconnect layer 18 is intended to include materials which are bendable in a radius or arc type manner or are sufficiently pliable to comprise a conformal layer (to an underlying surface). Conformal packages offer additional freedom when designing photodetection systems than flat planar-type embodiments. In some embodiments, as discussed below, a flexible interconnect layer is not required. In one embodiment with a flexible interconnect layer, for example, the flexible interconnect layer comprises polyimide having a thickness of about 50 micrometers. Other example materials include polyethylene terephthalate, polytetrafluoroethelyne, polyetherimide (such as the type sold under the trademark ULTEM by General Electric Co.), benzocyclobutene, and liquid crystal polymer. Electrical connections 20 may comprise any suitable material and in one example comprise copper. These connections may comprise a single layer or a multilayer embodiment embedded within the flexible interconnect layer. Flexible layer embodiments and electrical component alignment techniques are described in Cole et al., US5527741, and Saia et al., US6475877, respectively, for example.

In the example of FIG. 1, coupling of photodetector array 12 and processing electronics 14 is provided by attachment with solder balls 13 and 15. The solder ball type attachment can be accomplished by various techniques which depend upon the nature of the materials and connections. In another example, electrically conductive adhesive is used to couple the photodetector array and processing electronics. In one embodiment, backside contacts (on an opposing side from the active area side) are accomplished by either bringing the connections along edges of the array structure or, depending upon the material and thickness, construction of through-vias, in close proximity to the photodetector locations. In another embodiment wherein front side contacts are positioned at the periphery of the array (not shown), the flexible interconnect layer has an access window (not shown) therein, and the front side contacts are coupled directly to the flexible interconnect layer.

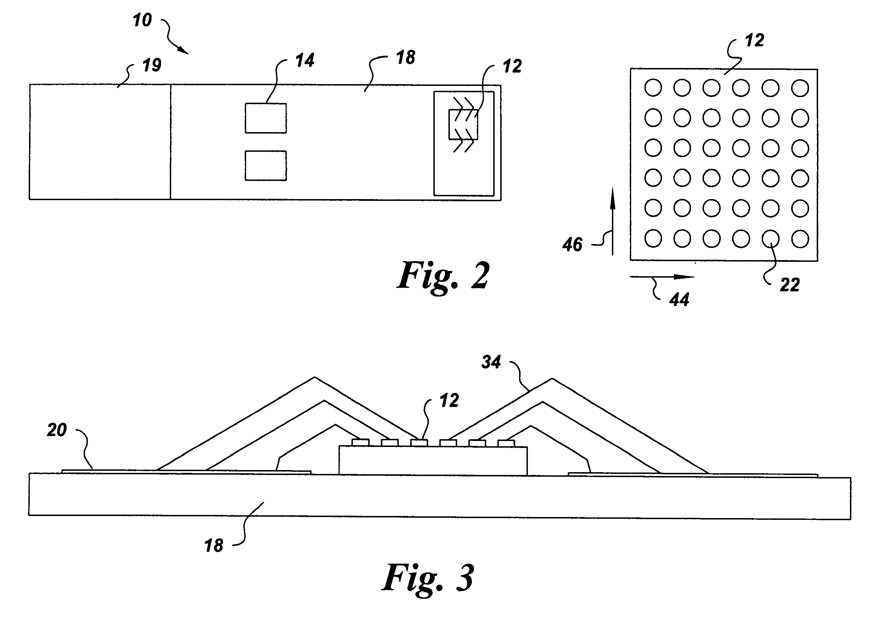

In contrast to the solder ball embodiment, FIGs. 2 and 3 are top and side views of a photodetection system in accordance with another embodiment wherein the coupling is accomplished by wire bonds 34. FIG. 2 additionally illustrates an embodiment wherein flexible layer 18 is further coupled to a rigid layer 19 such as a printed circuit board.

In one aspect of an embodiment wherein the photodetector array comprises a silicon carbide photodetector array, at least some of the silicon carbide photodetectors 22 of the photodetector array are configured for monitoring energy within a predetermined wavelength range of an ultraviolet spectrum. The responsivity envelope of a silicon carbide photodetector extends from about 200 nm to about 400 nm, which means that it is not intrinsically solar blind (that is, its responsivity is not intrinsically limited to wavelengths below about 300 nm or, more specifically, to the wavelength range from about 240 nm to about 280 nm).

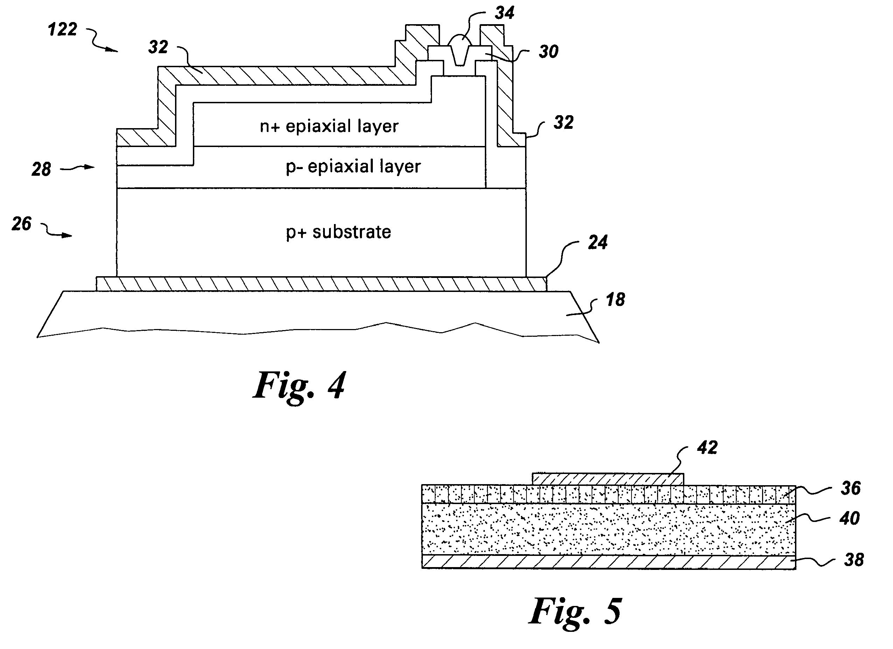

In a more specific aspect, as shown in FIG. 4, at least some of the silicon carbide photodetectors 122 are configured for monitoring energy within a predetermined wavelength range by being coupled with a respective filter 32 disposed in a position to intercept light directed toward the respective photodetector. Even more specifically, FIG. 4 illustrates an embodiment wherein a filter comprises an integral component of the photodetector by having been deposited on the photodetector. Such filters are described in detail in Brown et al., US2004/0200975. Multi-layer dielectric filters can be added to the wafer during processing in order to tailor the responsivity versus wavelength in order to serve various applications. If these types of filters are fabricated using inorganic compounds such as SiO₂ and HfO₂, the resulting silicon carbide photodetector-filter combination is extremely stable when exposed to high temperature and intense UV. Although a specific example has been provided for silicon carbide for purposes of illustration, such filters may also be used with other wide bandgap materials.

In more advanced embodiments, photodetection system 10 comprises a plurality of different filters 32 disposed to intercept different predetermined ranges of light directed toward respective photodetectors of the photodetector array. Such embodiments provide the benefit of being able to sense multiple components of the spectrum of interest. As another example, filters with different characteristics might be applied to alternate or adjacent pixels to create a multi-color UV video chip.

FIG. 5 is a side view of a photodetector including porous silicon carbide 36 in combination with a backside metal-coated 38 base 40 of silicon carbide and having an electrical contact 42 (typically indium-tin-oxide) coupled thereto. This embodiment, which can be optionally combined with the filter embodiments described above, provides even more flexibility because it can enable sensing light within a visible spectrum. The dark current characteristics of porous silicon carbide are comparable to those of nonporous silicon carbide and that the spectral responsivity for porous silicon carbide increases within the visible spectrum.

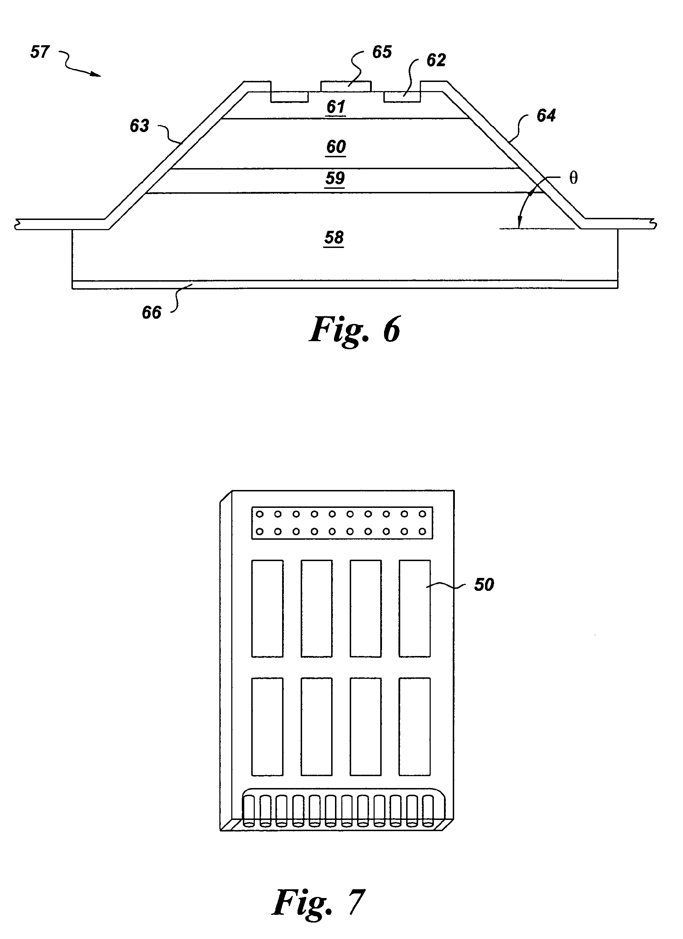

FIG. 6 is a side view of an avalanche photodetector (APD) 57. APDs are high-speed, high sensitivity photodetectors utilizing an internal gain mechanism that functions by applying a reverse voltage. Such photodetectors are particularly useful in photodetector array embodiments which are planned for situations wherein low light levels are present. In one exemplary embodiment, as described in Sandvik et al., US6838741, an avalanche photodetector comprises a substrate 58, a first epitaxial layer 59, a second epitaxial layer 60, a third epitaxial layer 61, a phosphorous silicate glass layer 62 on top of the third epitaxial layer for limiting mobile ion transport, passivation layers 63 and 64 extending over sloped sidewalls formed by the epitaxial layers, and electrodes 65 and 66.

Regardless of the type of photodetector, the array itself may comprise various layouts with one example layout of FIG. 2 including at least two directions 44 and 46 with at least two photodetectors 22 in each of the at least two directions. In a more specific embodiment, the array comprises exactly two directions with at least 512 elements in each of the exactly two directions. It is expected that such arrays may reach dimensions of 1024 by 1024 or more. To avoid exceptionally large arrays, however, the photodetection may include a plurality of tiled photodetector arrays 50, as illustrated by the perspective view of FIG. 7. Tiling is described in Burdick, Jr. et al., US2004/0109299 and permits a large scaling of detector size and thus a large field of view. Additionally, two dimensional tiling of detectors can be used to create a larger array from small, reasonable yield sub-arrays.

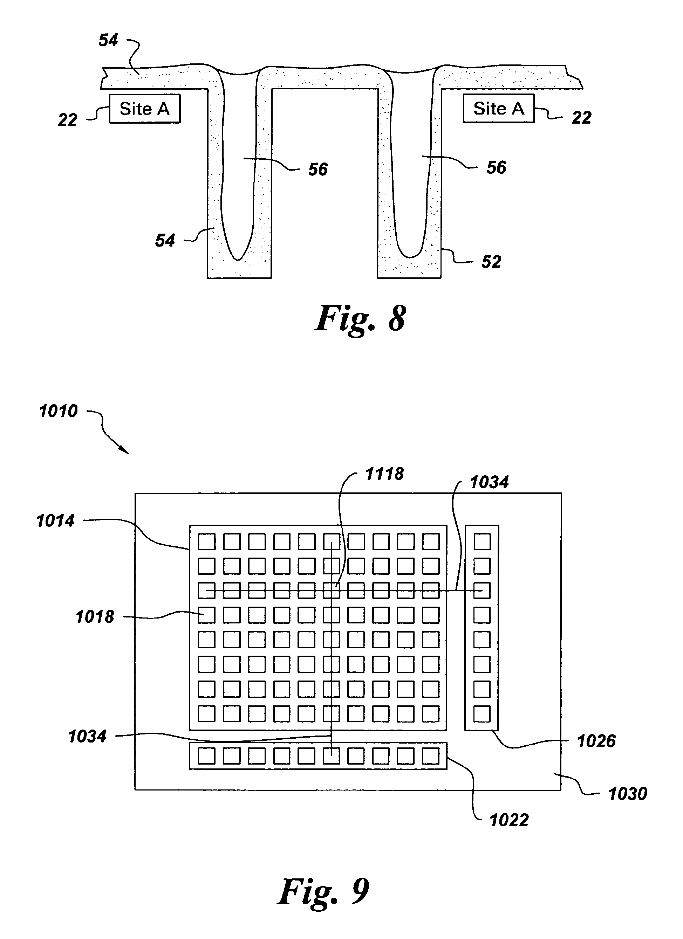

FIG. 8 is a side view of a photodetector isolation embodiment comprising at least one trench 52 in the photodetector array. The trench physically separates the photodetectors 22. The inside of the trench is coated with an electrically insulating material 54 and filled with an optically isolating material 56 that is conformally deposited, as described in Kretchmer et al., US2005/0101100. Such embodiments are useful for minimizing cross-talk within the arrays.

The photodetection system may be operably connected to any one of a number of devices and systems with several examples including an aircraft engine, a communication device, a pollution monitoring device, an X-ray detection device, a well logging tool, a hand-held security device, a glycol monitoring device, a flame imaging device, an industrial arc detection device, a bio-sensing array, a CT detector, and an ultraviolet astronomical device.

Processing electronics 14 (FIG. 1) may comprise any analog, digital, or combinations of analog and digital devices for obtaining and processing signals from the photodetector array. As used herein "processing signals" means the electrical alteration of electronic charge or current resulting from the photodetectors' response to electromagnetic radiation. An example of such alteration is the amplification of a current output from a photodetector, which is then provided to read out electronics. Several embodiments of processing techniques are provided in Garverick et al., US5371501, and in Rao et al., US6366231, for example. As a non-limiting example, in embodiments of Rao et al., US6366231, an analog to digital conversion circuit (not shown) is provided for converting an analog input signal into a plurality of binary output bits. The analog to digital conversion circuit includes an operational amplifier having an inverting terminal and an output terminal, and the analog input signal being connected to the inverting terminal. An integrating capacitor is connected between the inverting terminal and the output of the operational amplifier. The integrating capacitor stores a charge proportional to the integral of the input signal. A charge subtracting circuit is selectively coupled to the inverting terminal and the output of the operational amplifier. The charge subtracting circuit removes a first predetermined charge from the integrating capacitor when an output charge of the operational amplifier is substantially equal to a second predetermined charge.

Any one of a number of types of pixel arrangements are suitable for use in detection system embodiments. Several specific embodiments are described in below with respect to FIGs. 9-16. Briefly, for example, in one embodiment, a charge integrated device (CID) imager pixel comprises two MOS capacitors to move charge back and forth between their associated potential wells. A CID imager pixel is more radiation hard than a charge coupled (CCD) imager pixel because a CID imager pixel requires only two charge transfers to read out the charge accumulated during one frame time, whereas a CCD imager pixel requires multiple charge transfers. The array read out may alternatively be accomplished using two photodiodes per pixel with a transfer gate attached to one of the pair of photodiodes and with its other edge overlapping the other or with the pixels each comprising a photodetector coupled to a switch.

The previously described embodiments have many advantages, including the achievement of a fast read out, robust photodetection system with a scalable design offering the possibility of a number of photodetectors and geometries. Although the combination of the photodetector array, flexible interconnect layer, and processing electronics has been found to yield a particularly beneficial results, subcombinations are also beneficial and claimed herein. For example, one embodiment comprises a photodetection system comprising: a flexible interconnect layer including electrical connections and a wide bandgap photodetector array integrated on the flexible interconnect layer and coupled to the electrical connections. As another example, another embodiment comprises a photodetection system comprising: a wide bandgap photodetector array, processing electronics, and packaging configured for electrically integrating the photodetector array and the processing electronics, wherein the packaging and the processing electronics are configured for obtaining and processing signals detected by the photodetector array. In this embodiment, packaging of the photodetector array and processing electronics may be accomplished with any suitable substrate with one example of such a substrate comprising a rigid semiconductor substrate comprising a material such as silicon. Either subcombination embodiment may optionally include many of the specific detector and other features described above with respect to the larger combination. As yet another example, if desired, the pixel embodiments described with respect to FIGs. 9-16 may be used independently of the flexible interconnect layer and processing electronics embodiments.

FIG. 9 is a schematic block diagram of a wide bandgap focal plane array module 1010 in accordance with one embodiment wherein module 1010 comprises an array 1014 comprising a plurality of silicon carbide pixels 1018; a plurality of scan registers shown as 1022 and 1026; a substrate 1030 supporting array 1014 and scan registers 1022 and 1026; and a plurality of electrical interconnections 1034 coupling each pixel 1018 to at least two of the scan registers 1022 and 1026. Substrate 1030 may comprise any structurally suitable material, whether flexible or rigid, that is capable of providing support for the pixels and scan registers. In one embodiment, the substrate comprises a ceramic material such as alumina, for example. If desired, a box type arrangement may be coupled with the substrate and include a quartz or sapphire window over the region of interest.

Several examples of photodetector pixels 1018 are described below with respect to FIGs. 10-16. Ideally, the structure of array 1014 and the interconnections 1034 is configured to enable cross-point coupling of pixels 1018 to scan registers 1022 and 1026. One example of cross-point coupling is shown in FIG. 9 wherein pixel 1118 is coupled along interconnection lines 1034 to both scan register 1026 and scan register 1022. Such embodiments avoid the need of having each pixel individually coupled to a separate readout pad. Although a ninety degree orientation is shown, such orientations are not required. Additionally, the terms "row" and "column" are used below for purposes of description but are not intended to be limiting or requiring of a particular orientation. In one embodiment the scan registers comprise silicon scan registers such as silicon scan transistors. Several examples of such scan registers and methods for reading stored charge are described in Burke et al., US3993897. Although two scan registers 1022 and 1026 are shown for purposes of example, additional scan registers may be added if desired.

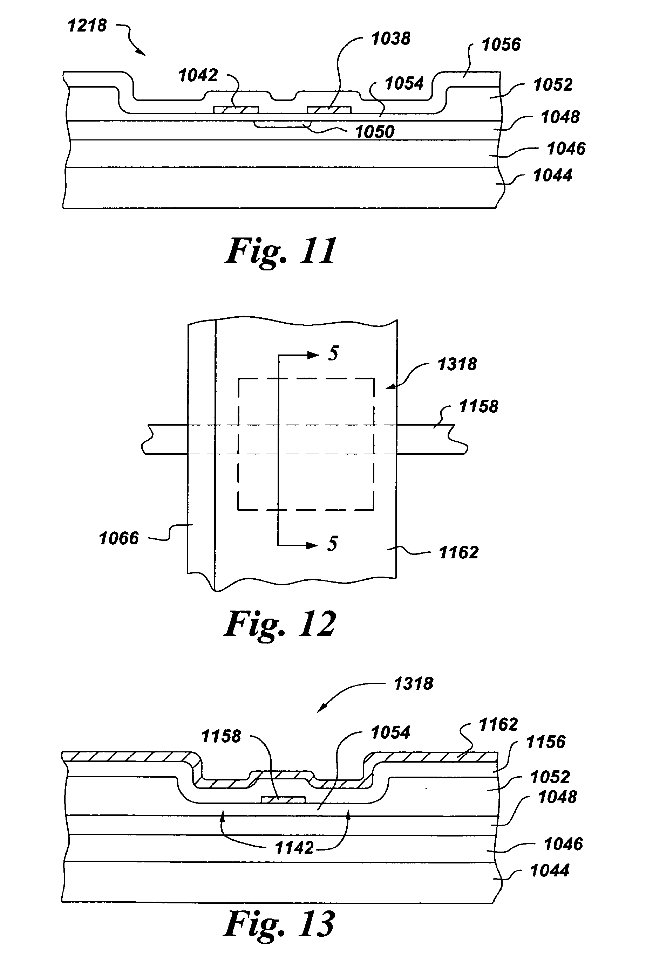

FIG. 10 is a top view of an array of photodetector pixels in accordance with another embodiment, and FIG. 11 is a sectional side view along line 3-3 of FIG. 10. In these embodiments, at least some of the photodetector pixels comprise a pair of coupled MOS (metal oxide semiconductor) capacitors 1038 and 1042.

In a more specific embodiment, which can be seen with respect to FIG. 11, the process sequence for the pair of MOS capacitors 1038 and 1042 begins with a silicon carbide structure comprising an n type silicon carbide substrate 1044, an n type silicon carbide epitaxial layer 1046, and a p type silicon carbide epitaxial layer 1048. A region 1050 is implanted with n+ conductivity followed by deposition of a first oxide layer 1052. In one example, epitaxial layer 1046 has a thickness of about 1-2 micrometers, epitaxial layer 1048 has a thickness of about 6 micrometers, implanted region 1050 has a thickness of about 1-2 micrometers, and first oxide layer 1052 has a thickness of about 1 micrometer. The conductivity types are for purposes of example and can be reversed if desired. Typically the oxide layers described herein comprise silicon oxides, but other oxides may be used if desired.

First oxide layer 1052 is thinned (either reduced or removed by any suitable technique) in the region where pixel 1218 is to be formed, and second oxide layer 1054 is deposited or thermally grown. In one example, the thickness of second oxide layer 1054 is about 400 angstroms. An optional silicon nitride (Si₃N₄) layer (not shown) may be provided over second oxide layer 1054, if desired, to reduce leakage.

A transparent, electrically conductive material layer 1040 is then applied (by deposition, for example) and patterned to form regions of capacitors 1038 and 1042 as well as row interconnections (shown by reference number 1058 in FIG. 10). As used herein, transparent includes material layers permitting at least about fifty percent (or in an even more specific example about eighty percent) of the light in the wavelength range of interest to pass therethrough. For example, platinum, depending upon the thickness, can be transparent over the wavelengths that silicon carbide devices respond to (about 200 nanometers to about 400 nanometers). As a platinum layer becomes thicker, transparency is decreased and conductivity is increased. Layer 1040 may be patterned by etching techniques, for example.

After patterning, a third oxide layer 1056 (FIG. 11) is applied. Vias 1064 (Fig. 10) may be provided, by etching for example, to extend down to layer 1040. In the embodiment of FIG. 10, layer 1040 includes landing pad regions 1041 between adjacent capacitor metallization in the pixels such that two adjacent pixels may share a column connection. Next a second level electrically conductive material layer 1059 is applied to provide column interconnections 1062. Second level electrically conductive material layer 1059 may also be used to provide landing pads 1060 to provide for connections to the scan registers. Layer 1059 need not be transparent. Several example materials include aluminum, titanium/molybdenum, and combinations thereof.

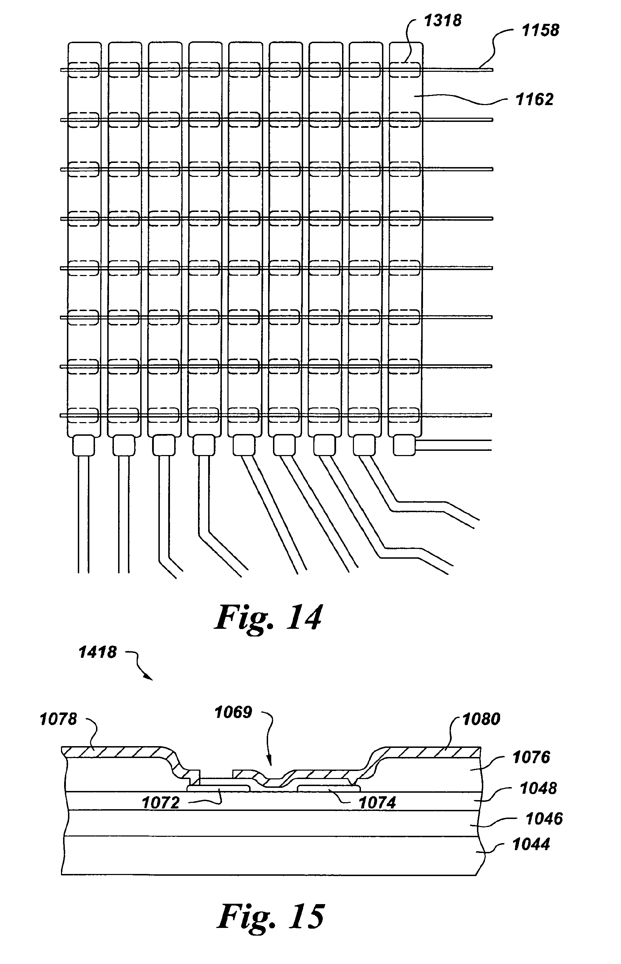

FIG. 12 is a top view of a of photodetector pixel 1318 arrangement in accordance with another embodiment, FIG. 13 is a sectional side view along line 5-5 of FIG. 12, and FIG. 14 is a top view illustrating a plurality of pixels 1318 similar to the pixel shown in FIG. 12. This embodiment is less complex than the embodiment of FIGs. 10-11 because implanted region 1050 (of FIG. 11) is not required and because no contact is required for individual pixel elements.

In one example, the process of this embodiment may begin in a similar manner as described with respect to FIG. 11 by providing a structure comprising an n type substrate 1044, an n type epitaxial layer 1046, and a p type epitaxial layer 1048 (but without the implanted region 1050), thinning or removing first oxide layer 1052 in the region where pixel 1318 is to be formed, and depositing or thermally growing second oxide layer 1054.

Then, first electrically conductive layer 1158 can be applied and patterned in a row orientation. Layer 1158 need not be transparent, particularly if it is sufficiently narrow. For example, quantum efficiency is maximized if the coverage of the row material of layer 1158 over the area of the pixel is limited to not exceed about twenty-five percent of the pixel area. Example materials include molybdenum and polysilicon. A third oxide layer 1156 is then applied over the structure with a thickness in one example being about 400 angstroms. In some embodiments, an optional Si₃N₄ layer (not shown) may be applied over third oxide layer 1156 with an example thickness being about 600 angstroms.

A second electrically conductive layer 1162 is then applied over the pixels and patterned in a column orientation. Layer 1162 is selected to be transparent (in a similar manner as discussed above with respect to FIG. 11) and may comprise a material such as platinum, aluminum nitride, aluminum gallium nitride (AlGaN), diamond-like-carbon thin films, thin carbon or any other material that is transparent, for example. In embodiments with AlGaN, the composition can be designed to limit the short wavelength sensitivity. Alternatively, multiple dielectric filters (not shown) can be deposited on top of the layer 1162 to control the responsivity as a function of wavelength and make the imager solar blind by substantially eliminating the long wavelength response (that is above about 250 nm). Filter embodiments are described in aforementioned Brown et al., US US2004/0200975, for example, and may be used in combination with any of the pixels described herein. Additionally, in this embodiment, to increase conductivity without reducing transparency, an electrically conductive strip 1066 may be applied and patterned along edges of layer 1162. In one embodiment, electrically conductive strips 1066 comprise aluminum. Other examples of strip materials include molybdenum, copper, and titanium, for example. Electrically conductive strips 1066 may be deposited and patterned either before or after patterning of second electrically conductive layer 1162.

FIG. 15 is a sectional side view of a photodetector pixel 1418 in accordance with another embodiment wherein at least some of the pixels comprise a pair photodiodes 1072 and 1074. In a more specific embodiment, the photodiodes comprise silicon carbide photodiodes. Typically, as shown in FIG. 15, the two photodiodes have a transfer gate 1069 between them. Pixel 1418 is not planar because photodetectors 1072 and 1074 are mesa-isolated and because contacts 1078 and 1080 to each of the n+ regions are formed. Thus packing density would not be as great as in the capacitor embodiments discussed above.

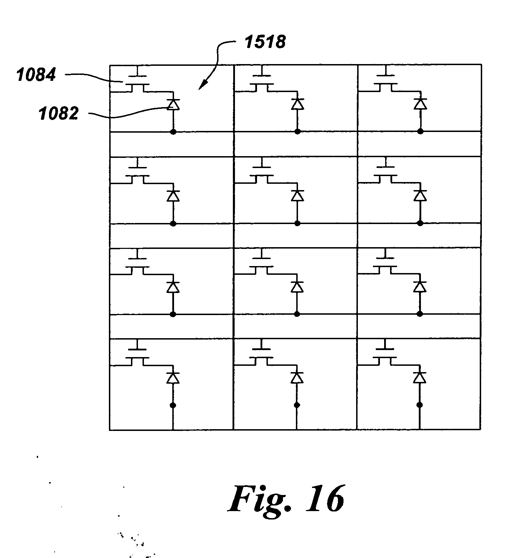

FIG. 16 is a schematic view of photodetector pixels 1518 in accordance with another embodiment wherein pixels 1518 comprise a photodetector 1082 coupled to a cross-point field effect transistor switch 1084. In a more specific embodiment, the photodetectors comprise silicon carbide photodiodes, for example.

While only certain features of various aspects and embodiments of the invention have been illustrated and described herein, many modifications and changes will occur to those skilled in the art. It is, therefore, to be understood that the appended claims are intended to cover all such modifications and changes as fall within the true spirit of the invention.

## Claims

1. A photodetection system (10) comprising:
a wide bandgap photodetector array (12);
processing electronics (14); and
packaging (16) comprising a flexible interconnect layer (18) including electrical connections (20),
wherein the packaging is configured for electrically integrating the photodetector array and the processing electronics, and
wherein the packaging and the processing electronics are configured for obtaining and processing signals detected by the photodetector array.

2. The system of claim 1 wherein the flexible interconnect layer comprises a conformal layer.

3. The system of claim 1 or claim 2 wherein the photodetector array comprises a silicon carbide photodetector array and wherein at least some of the silicon carbide photodetectors (22) of the photodetector array are configured for monitoring energy within a predetermined wavelength range of an ultraviolet spectrum by being configured with a respective filter (32) disposed in a position to intercept light directed toward the respective photodetector.

4. The system of any preceding claim further comprising a plurality of different filters (32) disposed to intercept different predetermined ranges of light directed toward respective photodetectors of the photodetector array.

5. The system of any preceding claim wherein the photodetector array comprises gallium nitride photodetectors, zinc oxide photodetectors, diamond photodetectors, or combinations thereof.

6. The system of any preceding claim operably connected to an aircraft engine, a communication device, a pollution monitoring device, an X-ray detection device, a well logging tool, a hand-held security device, a glycol monitoring device, a flame imaging device, an industrial arc detection device, a bio-sensing array, a CT detector, or an ultraviolet astronomical device.

7. The system of any preceding claim wherein at least some of the photodetectors comprise (a) a pair of coupled MOS capacitors; (b) a pair of photodetectors; (c) a photodetector coupled to a cross-point field effect transistor switch; or (d) combinations thereof.

8. A photodetection system (10) comprising:
a flexible interconnect layer (18) including electrical connections (20);
a wide bandgap photodetector array (12) integrated on the flexible interconnect layer and coupled to the electrical connections.

9. A wide bandgap semiconductor focal plane array module (1010) comprising:
an array (1014) comprising a plurality of imaging pixels (1018);
a plurality of scan registers (1022, 1026);
a substrate (1030) supporting the array and the scan registers; and
a plurality of electrical interconnections (1034) coupling each pixel to at least two of the scan registers.

10. The module of claim 9 wherein the focal plane array comprises silicon carbide pixels, gallium nitride pixels, zinc oxide pixels, or diamond pixels and wherein the array and the interconnections are configured to enable cross-point coupling of the pixels to the scan registers.

11. The module of claim 9 or claim 10 wherein the pixels comprise silicon carbide and wherein the scan registers comprise silicon scan registers.

12. The module of any one of claims 9 to 11 wherein at least some of the photodetector pixels comprise a pair of coupled MOS capacitors (1038, 1042), a pair photodiodes (1072, 1074), a photodetector (1082) coupled to a cross-point field effect transistor switch (1084), or combinations thereof.

13. A method for fabricating a silicon carbide pixel array (1014) comprising:
providing a silicon carbide substrate and at least two silicon carbide epitaxial layers over the substrate;
applying a first oxide layer over the substrate and epitaxial layers;
removing the first oxide layer in regions wherein pixels are to be formed;
applying a second, thinner oxide layer in the pixel regions;
applying a first electrically conductive layer in a row orientation across the pixel regions;
depositing a third oxide layer over the first electrically conductive layer and the first and second oxide layers;
applying a second electrically conductive layer in a column orientation across the pixel regions, the second electrically conductive layer comprising a transparent material; and
providing electrically conductive strips, each in contact with a respective edge of one column of the second electrically conductive layer.

14. The method of claim 13 wherein the second electrically conductive layer comprises platinum, and wherein the electrically conductive strips comprise aluminum.
